# EUROPEAN PATENT SPECIFICATION

(11) **EP 2 065 932 B1**
(45) Date of publication and mention of the grant of the patent: **06.11.2013**
(21) Application number: 07807649.4
(22) Date of filing: 20.09.2007
(51) Int. Cl.: H01L 23/373, H05K 7/20, H01L 23/433

(54) **METHOD FOR MANUFACTURING A THERMAL INTERFACE STRUCTURE**
VERFAHREN ZUR HERSTELLUNG EINER THERMISCHEN GRENZFLÄCHENSTRUKTUR
PROCÉDÉ DE FABRICATION D'UNE STRUCTURE D'INTERFACE THERMIQUE

(30) Priority: 22.09.2006 JP 2006258091
(43) Date of publication of application: 03.06.2009
(73) Proprietor: International Business Machines Corporation, Armonk, NY 10504 (US)
(72) Inventor: SUEOKA, Kuniaki, Kanagawa 242-8502 (JP); TAIRA, Yohichi, Kanagawa 242-8502 (JP)
(74) Representative: Williams, Julian David
(86) International application number: PCT/JP2007/068297
(87) International publication number: WO 2008/035742

(56) References cited:
- JP-A- 9 321 190
- JP-A- 2003 249 613
- JP-A- 2005 116 839
- JP-A- 2006 147 801
- JP-A- 2006 290 736
- US-A1- 2004 261 987
- US-A1- 2005 167 647

## Description

The present invention relates generally to a manufacturing method of a thermal conduction structure. Specifically, the present invention relates to a manufacturing method of a thermal interface structure capable of being used in a thermal conduction module in which integrated circuit (IC) chips or the like are embedded.

In recent years, the power consumption of semiconductor ICs has been continued to increase with the development of the higher-density ICs. The increase in the electric power leads to an increase in the amount of heat generated, and then results in one of the reasons to hinder the improvement in clock frequencies of the semiconductor ICs. For this reason, the semiconductor ICs need to be cooled at a high efficiency for further improvement in clock frequencies of the semiconductor ICs or the like. As a structure for cooling a semiconductor IC, a thermal contact material (thermal interface structure) is provided between the semiconductor IC and a heat radiating mechanism (heat sink) to mitigate the influence of thermal expansion. The thermal resistance at this interface is high, and makes up about a half of the thermal resistance in the entire cooling system. Accordingly, what has been longed for is a thermal interface structure with thermal resistance as low as possible.

In such a circumstance, a carbon nanotube (hereinafter referred to as "CNT"), which has a high thermal conductivity and high mechanical flexibility, is expected to be used as the thermal contact material. H. Ammita et al., "Utilization of carbon fibers in thermal management of Microelectronics, " 2005 10th International Symposium on Advanced Packaging Materials: Processes, Properties and Interfaces, 259 (2005) discloses a use of CNTs as a thermal contact material (grease) by incorporating the CNTs into fats, oils, or the like. US Patent 6, 965, 513 discloses that CNTs orientationally grown are used as a thermal contact material into which the CNTs are formed by binding together with use of an elastomer or the like. However, in any of these disclosures, a low thermal resistance value down to a practical level is not obtained. This is because there exists a high contact resistance between the CNTs and the substrate with which the CNTs come into contact. For this reason, a method is demanded in which a low thermal resistance (high thermal coupling) is achieved between CNTs and the substrate.

Other examples of conventional CNT based thermal interfaces are described in US 2005/016767 US 2004/0261987 and JP-A-9321190.

In accordance with the present invention, there is now provided a method of manufacturing a thermal interface structure comprising the steps of: providing a carbon nanotube layer on a substrate, the carbon nanotubes of which are aligned in a direction perpendicular to the substrate; and, separating the substrate and the carbon nanotube layer from each other; characterized in that the method comprises: providing a first metal layer on the surface of carbon nanotube layer remote from the substrate; and, providing a second metal layer on the surface of the carbon nanotube layer, which is exposed by the separation; wherein the step of separating the substrate and the carbon nanotube layer from each other includes the steps of: coating a liquid metal on a surface of the first metal layer; joining a metal block to the substrate such that the liquid metal comes into contact with a surface of the metal block; cooling the joined substrate and metal block; separating the substrate and the carbon nanotube layer from each other after the cooling; and removing the liquid metal and the metal block from the first metal layer after the separation.

Examples of the present invention advantageously provide a thermal interface structure with a low thermal resistance.

Examples of the present invention also provide a thermal conduction module with a high thermal conduction efficiency.

Examples of the present invention also provide a thermal interface structure which includes: an oriented carbon nanotube layer; and metal layers respectively provided on two surfaces of the carbon nanotube layer, the surfaces being located in the directions to which edges of the carbon nanotubes are oriented (hereinafter, the surfaces will be referred to as "edge surfaces").

Examples of the present invention also provide a thermal conduction module which includes: a heating body; a radiator; and a thermal interface structure provided between the heating body and the radiator. The thermal interface structure includes: a carbon nanotube layer in which the carbon nanotubes are oriented in substantially parallel to a direction from the heating body to the radiator; a first metal layer connected to one of the edge surfaces of the carbon nanotube layer, and thermally connected to the heating body; and a second metal layer connected to the other of the edge surfaces of the carbon nanotube layer, and thermally connected to the radiator.

For a more complete understanding of the present invention and the advantage thereof, reference is now made to the following description taken in conjunction with the accompanying drawings, in which:
Fig. 1 is a diagram showing a cross section of a thermal interface structure of the present invention;
Fig. 2 is a diagram showing a cross section of a thermal conduction module of the present invention;
Fig. 3 is a diagram showing a method of manufacturing a thermal interface structure of an embodiment of the present invention; and,
Fig. 4 is a diagram showing another method of manufacturing a thermal interface structure of an embodiment of the present invention.

In embodiments of the present invention, in order to reduce a contact resistance, metal layers are provided between surfaces of a CNT layer and of a substrate or the like which faces the CNT layer. The metal layers are formed by, for example, a sputtering method as continuous metal layers on the surfaces of the layer of CNTs that are orientationally grown. Furthermore, the surfaces of the metal layers can further be thermally coupled to a substrate or the like by use of a low-melting-point metal, for example. With these components, examples of the present invention accomplish a thermal conduction structure with a low thermal resistance. The orientation, the high thermal conductivity and the mechanical flexibility of the CNTs are fully utilized to accomplish the above-mentioned goal. Examples of the present invention will be described in detail below with reference to the appended drawings.

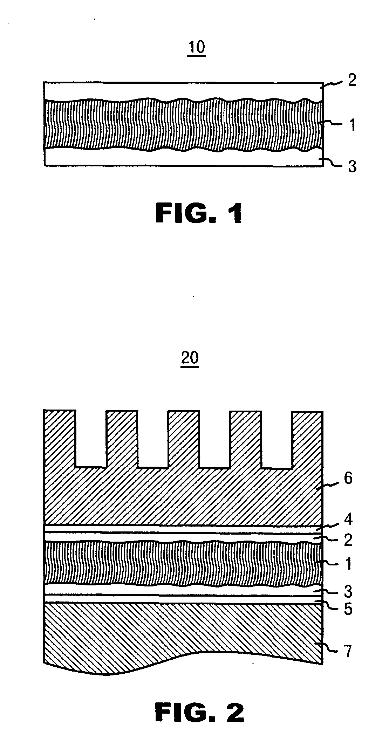

Fig. 1 shows a cross section of a thermal interface structure 10 of the present invention. The thermal interface structure 10 includes a CNT layer 1 and metal layers 2 and 3. The CNTs of the CNT layer 1 are oriented in substantially parallel to a direction of thermal transmission (approximately vertical direction in Fig. 1). The CNT is a one-dimensional thermal conductive substance. Although the thermal conductivity in a direction of the longitudinal axis of the tube of the CNT is considerably large, the thermal conductivity in a direction perpendicular to the longitudinal axis (that is, horizontal direction) is small. Thus, in examples of the present invention, the direction in which the CNTs of the CNT layer are oriented is preferably a direction along (parallel to) the direction of the longitudinal axis of the tube of the CNT. The metal layers 2 and 3 are respectively joined to the upper surface and lower surface of the CNT layer 1. The metal layers are preferably made of a metal selected from the group consisting of Au, Ni and Pt. Other metals, such as Ag, may be used as the metal layers. In order to increase the mechanical strength of the CNT layer, an elastic material such as a Si elastomer can be interspersed between the CNTs of the CNT layer 1.

Fig. 2 shows a cross section of a thermal conduction module 20 of the present invention. Fig. 2 shows that the thermal interface structure 10 shown in Fig. 1 is used. The metal layer 2 on the upper side of the thermal interface structure is connected to a heat sink 6 with a low-melting-point metal material (for example, Ga, an alloy thereof, or the like) or a solder material (for example, Pb-Sn) interposed therebetween. Herein, the low-melting-point metal material or the solder material is denoted by the reference numeral 4. Likewise, the metal layer 3 on the lower side of the thermal interface structure is connected to a heating body 7 with a low-melting-point metal material or a solder material interposed therebetween. In this case, the low-melting-point metal material or the solder material is denoted by the reference numeral 5. The heating body 7 is, for example, a semiconductor IC (IC chip). The heat sink 6 is made of a material with a high thermal conductivity such as aluminum. An example of the IC chip includes micro-processor unit (MPU) or the like.

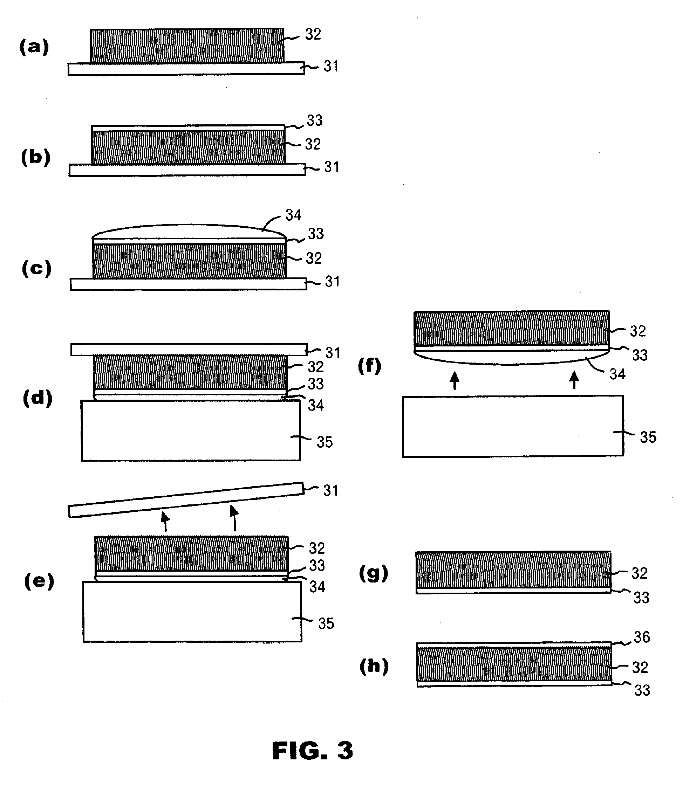

Fig. 3 shows an embodiment of a method of manufacturing the thermal interface structure of the present invention. In step (a), on a Si substrate 31, CNTs of a CNT layer 32 are grown as oriented in the vertical direction. The CNTs are grown, for example, in a container for the thermal CVD into which an acetylene gas is introduced while the substrate temperature is set at 750°C. The thickness of the CNT layer 32 is approximately 30 µm to 150 µm. In step (b), a metal layer 33 is formed on a surface of the CNT layer 32. For example, by the use of a sputtering apparatus, an Au layer is formed in a thickness of approximately 1 µm. The thickness of the metal layer 33 may be approximately 0.5 µm to 5 µm. This relatively thick metal layer 33 improves the thermal coupling as well as the mechanical strength of the CNT layer 32. Accordingly, a disturbance of the orientation of the CNTs is prevented. In step (c), a liquid metal layer 34 (for example, Ga) is coated on a surface of the metal layer 33. In step (d), the substrate 31 is joined to a metal (for example, copper) block 35 so that the liquid metal layer 34 can come into contact with a surface of the metal block 35. Thereafter, the entire structure or a portion thereof corresponding to the liquid metal layer 34 is cooled from the outside to solidify the liquid metal layer 34. The cooling temperature is, for example, not higher than approximately 4°C in a case of a Gabased liquid metal. Due to this solidification, the substrate 31 (the CNT layer 32) and the metal block 35 is coupled to each other with the liquid metal layer 34 interposed therebetween. Note that, instead of cooling the entire structure or the portion thereof corresponding to the liquid metal layer 34 from the outside, the metal block 35 may be prepared in advance by cooling down to the temperature or below at which the liquid metal layer 34 can be solidified. Subsequently, the liquid metal layer 34 is joined to the surface of the metal block 35.

In step (e), the substrate 31 and the CNT layer 32 are separated from each other by removing the substrate 31 from the CNT layer 32. In step (f), the entire structure or the portion thereof corresponding to the liquid metal layer 34 is heated from the outside to melt the solidified liquid metal layer 34. Then, the CNT layer 32 is separated from the metal block 35. In step (g), the melted liquid metal layer 34 is removed from the surface of the metal layer 33. In step (h), on the exposed surface of the CNT layer 32, a metal layer 36 is formed in a similar way to that in the case of step (b). Through a series of the steps described above, a thermal interface structure using the CNT layer is manufactured. Note that, after step (g), a flowable elastic material such as a Si elastomer may be impregnated in each gap between the CNTs of the CNT layer 32 in a vacuum container. Due to the solidification of the elastic material, the mechanical strength of the CNT layer 32 can be increased.

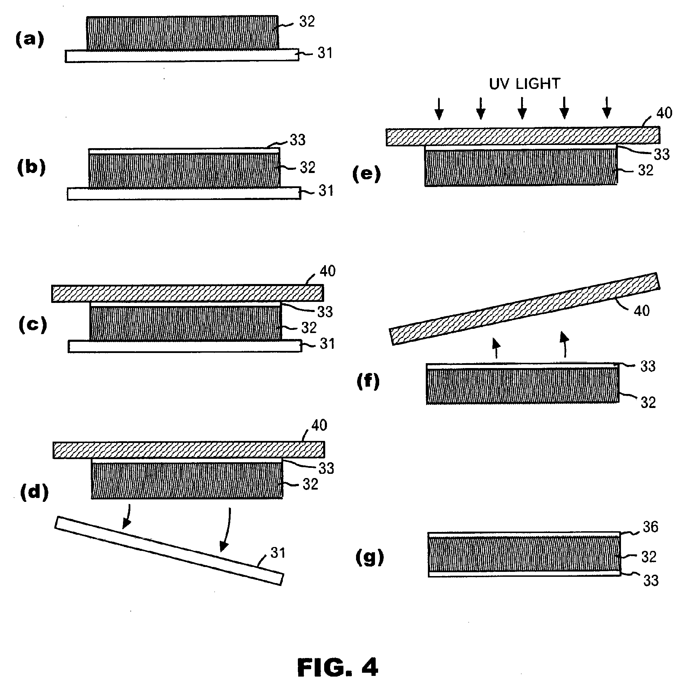

Fig. 4 shows another embodiment of the method of manufacturing the thermal interface structure of the present invention. Steps (a) and (b) are the same as in the case of Fig. 3. In step (c), on the surface of the metal layer 33, an ultraviolet (UV)-removable tape 40 is attached. The UV-removable tape is an adhesive tape with which an adhesion layer thereof can be removed from a target to be adhered. Specifically, the adhesion layer is degraded by irradiating with a UV light to generate a gas (air bubble), and then the adhesion layer is removed therefrom. In step (d), the substrate 31 and the CNT layer 32 are separated from each other by removing the substrate 31 from the CNT layer 32. In step (e), by irradiating the UV-removable tape 40 with a UV, the adhesion layer is degraded. In step (f), the UV-removable tape 40 and the metal layer 33 are separated from each other by removing the UV-removable tape 40 from the surface of the metal layer 33. At this time, in a case where a residue of the adhesion agent remains on the surface of the metal layer 33 after the removal, the residue is removed by ozone cleaning or the like. In step (g), on the surface of the CNT layer 32, the metal layer 36 is formed as in the case of step (h) shown in Fig. 3. Through a series of the steps described above, a thermal interface structure using the CNT layer is manufactured. Note that, after step (g), in a vacuum container, an elastic material such as a Si elastomer may be impregnated in each gap between the CNTs of the CNT layer 32. Due to the solidification of the elastic material, the mechanical strength of the CNT layer 32 can be increased.

A measurement was made on a thermal resistance of the thermal interface structure manufactured according to the method shown in Fig. 3. The steady state method was used in the measurement. The steady state method is one generally in which a constant joule heat is provided for a sample to obtain a thermal conductivity based on a heat flux Q and a temperature gradient ΔT at the time of providing the heat. The sample had an area of 10 mm × 10 mm, and a thickness of several tens of micrometers to a hundred micrometers. The sample was sandwiched between two copper blocks having a thermocouple. One end of the copper blocks was heated with a heater, and the other end was cooled with the heat sink. Between both ends, a constant heat flux Q was generated to measure a temperature gradient ΔT at that time. A thermal resistance R was obtained according to the formula R = ΔT / Q. To be more specific, the values of ΔT corresponding to a plurality of Qs were plotted on a graph, and the thermal resistance R was obtained by linearly fitting (approximating) the values. The actually obtained thermal resistance value was 18 mm²K/W (film thickness: 80 µm). The thermal resistance values in a case of using CNT-coated Si as shown in Fig. 8 of, or in a case of using CNT-coated Cu(Si) as shown in Fig. 10 of, the above described document "Utilization of carbon fibers in thermal management of Microelectronics" were respectively 110 mm²K/W or 60 mm²K/W. Compared with the document, the thermal resistance value of the present invention was not larger than about one-third of these thermal resistance values.

Examples of the present invention has been described with reference to the drawings. However, the present invention is not limited to the embodiments described above. It will be apparent to those skilled in the art that any modification can be made within the scope of the present invention.

## Claims

1. A method of manufacturing a thermal interface structure (10) comprising the steps of:
providing a carbon nanotube layer (32) on a substrate (31), the carbon nanotubes of which are aligned in a direction perpendicular to the substrate; and,
separating the substrate and the carbon nanotube layer from each other;
**characterized in that** the method comprises:
providing a first metal layer (33) on the surface of carbon nanotube layer remote from the substrate; and,
providing a second metal layer (36) on the surface of the carbon nanotube layer, which is exposed by the separation;
wherein the step of separating the substrate and the carbon nanotube layer from each other includes the steps of:
coating a liquid metal (34) on a surface of the first metal layer;
joining a metal block (35) to the substrate such that the liquid metal comes into contact with a surface of the metal block;
cooling the joined substrate and metal block;
separating the substrate and the carbon nanotube layer from each other after the cooling; and
removing the liquid metal and the metal block from the first metal layer after the separation.

2. The method according to claim 1, wherein at least one of the steps of providing the first metal layer and of providing the second metal layer includes a step of forming the metal layer by sputtering.

3. The method according to claim 1, further comprising a step of permeating an elastic material in each gap between the carbon nanotubes of the carbon nanotube layer.

4. The method according to any preceding claim, wherein the first and second layers are made of a metal selected from the group consisting of Au, Ni and Pt.

## Patentansprüche

1. Verfahren zur Herstellung einer thermischen Grenzflächenstruktur (10), aufweisend die Schritte:
Bereitstellen einer Kohlenstoff-Nanoröhrchen-Schicht (32) auf einem Substrat (31), deren Kohlenstoff-Nanoröhrchen in eine Richtung senkrecht zu dem Substrat ausgerichtet sind; und
Trennen des Substrats und der Kohlenstoff-Nanoröhrchen-Schicht voneinander;
**dadurch gekennzeichnet, dass das Verfahren aufweist:**
Bereitstellen einer ersten Metallschicht (33) auf der von dem Substrat entfernten Fläche der Kohlenstoff-Nanoröhrchen-Schicht; und
Bereitstellen einer zweiten Metallschicht (36) auf der Fläche der Kohlenstoff-Nanoröhrchen-Schicht, die durch die Trennung frei gelegt wird;
wobei der Schritt des Trennens des Substrats und der Kohlenstoff-Nanoröhrchen-Schicht voneinander die folgenden Schritte umfasst:
Schichten eines flüssigen Metalls (34) auf eine Fläche der ersten Metallschicht;
Verbinden eines Metallblocks (35) mit dem Substrat, so dass das flüssige Metall mit einer Fläche des Metallblocks in Kontakt kommt;
Kühlen des miteinander verbundenen Substrats und Metallblocks;
Trennen des Substrats und der Kohlenstoff-Nanoröhrchen-Schicht voneinander nach dem Kühlen; und
Entfernen des flüssigen Metalls und des Metallblocks von der ersten Metallschicht nach der Trennung.

2. Verfahren nach Anspruch 1, wobei mindestens einer der Schritte des Bereitstellens der ersten Metallschicht und des Bereitstellens der zweiten Metallschicht einen Schritt des Bildens der Metallschicht durch Sputtern umfasst.

3. Verfahren nach Anspruch 1, welches ferner einen Schritt des Eindringens eines elastischen Materials in jede Lücke zwischen den Kohlenstoff-Nanoröhrchen der Kohlenstoff-Nanoröhrchen-Schicht aufweist.

4. Verfahren nach einem der vorhergehenden Ansprüche, wobei die erste und zweite Schicht aus einem Metall hergestellt werden, das aus der Gruppe ausgewählt wird, die aus Au, Ni und Pt besteht.

## Revendications

1. Procédé de fabrication d'une structure d'interface thermique (10) comprenant les étapes de :
fourniture d'une couche de nanotubes de carbone (32) sur un substrat (31), dont les nanotubes de carbone sont alignés dans une direction perpendiculaire au substrat, et,
séparation l'un de l'autre du substrat et de la couche de nanotubes de carbone ;
**caractérisé en ce que le procédé comprend :**
la fourniture d'une première couche de métal (33) sur la surface de la couche de nanotubes de carbone éloignée du substrat ; et,
la fourniture d'une seconde couche métallique (36) sur la surface de la couche de nanotubes de carbone, qui est rendue apparente par la séparation ;
où l'étape de séparation l'un de l'autre du substrat et de la couche de nanotubes de carbone inclut les étapes :
d'enduction de la surface de la première couche de métal par un métal liquide (34) ;
de raccordement d'un bloc en métal (35) au substrat de telle sorte que le métal liquide arrive au contact de la surface du bloc en métal ;
de refroidissement du substrat raccordé et du bloc en métal ;
de séparation l'un de l'autre du substrat et de la couche de nanotubes en carbone après le refroidissement ; et
d'enlèvement du métal liquide et du bloc en métal de la première couche métallique après la séparation.

2. Procédé selon la revendication 1, dans lequel au moins l'une des étapes parmi la fourniture de la première couche métallique et la fourniture de la seconde couche métallique inclut une étape de formation de la couche métallique par pulvérisation cathodique.

3. Procédé selon la revendication 1, comprenant en outre une étape d'infiltration d'un matériau élastique dans chaque espace entre les nanotubes de carbone de la couche en nanotubes de carbone.

4. Procédé selon l'une quelconque des revendications précédentes, dans lequel la première et la seconde couche sont faites d'un métal choisi dans le groupe constitué par Au, Ni et Pt.
